# EUROPÄISCHE PATENTSCHRIFT

(11) **EP 4 616 683 B1**
(45) Veröffentlichungstag und Bekanntmachung des Hinweises auf die Patenterteilung: **16.09.2026**
(21) Anmeldenummer: 23798184.0
(22) Anmeldetag: 25.10.2023
(51) Int. Cl.: H05K 1/02, H05K 3/46

(54) **VERFAHREN ZUM ERKENNEN EINER DELAMINATION EINER BESCHICHTUNG EINER LEITERPLATTE EINES FELDGERÄTS DER PROZESS- UND AUTOMATISIERUNGSTECHNIK**
METHOD FOR DETECTING A DELAMINATION OF A COATING OF A PRINTED CIRCUIT BOARD OF A FIELD DEVICE IN PROCESS AND AUTOMATION TECHNOLOGY
PROCÉDÉ DE DÉTECTION D'UNE DÉLAMINATION D'UN REVÊTEMENT D'UNE CARTE DE CIRCUIT IMPRIMÉ D'UN APPAREIL DE TERRAIN EN TECHNIQUE DE PROCESSUS ET D'AUTOMATISATION

(30) Priorität: 11.11.2022 DE 102022129897
(43) Veröffentlichungstag der Anmeldung: 17.09.2025
(73) Patentinhaber: Endress+Hauser SE+Co. KG, 79689 Maulburg (DE)
(72) Erfinder: BIRGEL, Dietmar, 79650 Schopfheim (DE); BURGER, Paul, 79650 Schopfheim (DE); CZAJA, Silke, 79650 Schopfheim (DE)
(74) Vertreter: Endress + Hauser Group Services (Deutschland) AG+Co. KG
(86) Internationale Anmeldenummer: PCT/EP2023/079823
(87) Internationale Veröffentlichungsnummer: WO 2024/099778

(56) Entgegenhaltungen:
- DE-A1- 102020 108 456
- JP-A- 2001 085 845
- US-A1- 2002 101 256
- US-A1- 2005 252 311

## Beschreibung

Die Erfindung betrifft ein Verfahren zum Erkennen einer Delamination mindestens einer Beschichtung einer Leiterplatte eines Feldgeräts der Prozess- und Automatisierungstechnik, welches zur Bestimmung und/oder Überwachung mindestens eines chemischen und/oder physikalischen Parameters eines Mediums dient, wobei die Leiterplatte einen ersten Bereich mit der mindestens einen Beschichtung aufweist, wobei mindestens eine wärmeleitende Komponente im Bereich der mindestens einen Beschichtung angeordnet ist, wobei mindestens ein Indikatorabschnitt auf der Leiterplatte angeordnet ist, welcher die mindestens eine Beschichtung und die mindestens eine wärmeleitende Komponente aufweist.

Feldgeräte in der Prozess- und Automatisierungstechnik dienen der Überwachung und/oder Bestimmung mindestens einer, beispielsweise chemischen oder physikalischen, Prozessgröße eines Mediums. Im Rahmen der vorliegenden Anmeldung werden im Prinzip alle Messgeräte als Feldgerät bezeichnet, die prozessnah eingesetzt werden und die prozessrelevante Informationen liefern oder verarbeiten. Eine Vielzahl solcher Feldgeräte wird von Firmen der Endress + Hauser-Gruppe hergestellt und vertrieben.

Bei der von dem Feldgerät zu bestimmenden Prozessgröße kann es sich um den Füllstand, den Durchfluss, den Druck, die Temperatur, den pH-Wert, ein Redoxpotential, oder die Leitfähigkeit des jeweiligen Mediums handeln. Die der Bestimmung der Prozessgröße zugrundeliegenden unterschiedlichen, möglichen Messprinzipien sind aus dem Stand der Technik bekannt und werden hier nicht weiter erläutert. Feldgeräte zur Messung des Füllstands sind insbesondere als Mikrowellen-Füllstandsmessgeräte, Ultraschall-Füllstandsmessgeräte, zeitbereichsreflektometrische Füllstandsmessgeräte (TDR), radiometrische Füllstandsmessgeräte, kapazitive Füllstandsmessgeräte, konduktive Füllstandsmessgeräte und vibronische Füllstandsmessgeräte ausgestaltet. Feldgeräte zur Messung des Durchflusses dagegen arbeiten beispielsweise nach dem Coriolis-, Ultraschall-, Vortex-, thermischen und/oder magnetisch induktiven Messprinzip. Bei Druckmessgeräten handelt es sich bevorzugt um sogenannte Absolut-, Relativ- oder Differenzdruckgeräte. Neben den zuvor genannten Messgeräten und Aktoren werden unter Feldgeräten auch Remote I/Os, Funkadapter bzw. allgemein Geräte verstanden, die auf der Feldebene angeordnet sind.

Ein Feldgerät umfasst typischerweise einen zumindest teilweise und/oder zumindest zeitweise mit dem Prozess in Berührung kommenden Sensor und eine Elektronikeinheit, welche beispielsweise der Signalerfassung, Signalauswertung und/oder Signalspeisung dient. Die Elektronikeinheit des Feldgeräts ist typischerweise in einem Gehäuse angeordnet und verfügt zusätzlich über mindestens ein Anschlusselement zum Anschluss der Elektronikeinheit an den Sensor und/oder eine externe Einheit und zum Übertragen von Daten und/oder Energie. Das Anschlusselement kann eine beliebige Verbindung sein, auch eine drahtlose Verbindung ist einsetzbar. Die Elektronikeinheit und der Sensor des Feldgeräts können in Form separater Einheiten mit getrennten Gehäusen oder als eine gemeinsame Einheit mit einem Gehäuse ausgestaltet sein. In der Regel weist das Feldgerät mindestens eine Leiterplatte mit darauf angeordneten Bauteilen auf.

Leiterplatten bestehen aus einem elektrisch isolierendem Material mit daran haftenden, leitenden Verbindungen, welche typischerweise aus Kupfer gefertigt werden. Mehrlagige Leiterplatten weisen auf beiden Seiten der Leiterplatte leitende Verbindungen auf. Zur Herstellung einer mehrlagigen Leiterplatte können beispielsweise zwei Leiterplatten mittels eines sogenannten Prepregs miteinander verklebt werden. Prepregs sind mit Reaktionsharzen vorimprägnierte textile Faser-Matrix-Halbzeuge, die zur Herstellung der mehrlagigen Leiterplatte unter Temperatur und Druck ausgehärtet werden. Auf diese Weise lassen sich auch verschiedene Eigenschaften von Leiterplatten verbinden: so kann ein Abschnitt der Leiterplatte eine starre, dicke Leiterplatte sein, wohingegen ein weiterer Abschnitt der Leiterplatte, mit welchem die starre Leiterplatte verklebt wird, eine flexible Leiterplatte ist. Das Ergebnis ist dann eine starrflexible Leiterplatte mit starren und flexiblen Bereichen. Flexible Leiterplatten weisen häufig Polyimid-Folien als Basis auf, auf welcher elektrische leitfähige Strukturen aufgebracht sind.

Leiterplatten werden typischerweise mindestens einem Heizvorgang ausgesetzt. Dabei kommt es gelegentlich vor, dass eine Delamination, also eine Ablösung, einer Beschichtung der Leiterplatte auftritt, was dazu führt, dass die Leiterplatte, in der Regel samt ihrer zugehörigen Charge, entsorgt werden muss.

US 2002/101256 A1 offenbart ein Verfahren zum Erkennen von abgelösten Kontaktflächen auf einer Leiterplatte. Delaminationen werden durch die Entwicklung einer Opferleiterbahn erkannt, die an einem Ende durch eine Durchkontaktierung verankert ist und am anderen Ende mit einer Kontaktfläche verbunden ist.

Die Opferspur ist zerbrechlich. Durch die Ablösung der Kontaktfläche wird die Opferleiterbahn unterbrochen, wodurch ein Stromkreis unterbrochen wird, was zur Erkennung des Fehlers genutzt wird.

Weitere Verfahren und Vorrichtungen zur Untersuchung des Zustands von

Leiterplatten sind aus der JP 2001 085845 A, der US 2005/252311 A1 und der DE 10 2020 108 456 A1 bekannt geworden.

Die Aufgabe der vorliegenden Erfindung ist es daher, ein Verfahren anzugeben, mittels welcher der Ausschuss aufgrund von Delamination der Leiterplatte verringert wird.

Erfindungsgemäß wird die Aufgabe gelöst durch ein Verfahren zum Erkennen einer Delamination mindestens einer Beschichtung einer Leiterplatte eines Feldgeräts der Prozess- und Automatisierungstechnik, welches zur Bestimmung und/oder Überwachung mindestens eines chemischen und/oder physikalischen Parameters eines Mediums dient, wobei die Leiterplatte einen ersten Bereich mit der mindestens einen Beschichtung aufweist, wobei mindestens eine wärmeleitende Komponente im Bereich der mindestens einen Beschichtung angeordnet ist, wobei mindestens ein Indikatorabschnitt auf der Leiterplatte angeordnet ist, welcher die mindestens eine Beschichtung und die mindestens eine wärmeleitende Komponente aufweist, wobei das Verfahren zumindest die folgenden Schritte umfasst:
- Einbringen der Leiterplatte in einen Ofen und Durchführen mindestens eines Heizvorgangs,
- Überprüfen des mindestens einen Indikatorabschnitts nach dem mindestens einen Heizvorgang hinsichtlich einer Delamination,
- Feststellen, ob eine Delamination im mindestens einen Indikatorabschnitt während des mindestens einen Heizvorgangs aufgetreten ist.

Der Erfindung liegt die Erkenntnis zugrunde, dass bei noch vorhandener Feuchtigkeit in der Leiterplatte, insbesondere bei Anwesenheit wärmeleitfähiger Komponenten im Bereich der Beschichtung, Delaminationen verstärkt auftreten. Ein frühzeitiges Erkennen der Delamination wird durch den erfindungsgemäßen Indikatorabschnitt ermöglicht. Der Begriff Delamination umfasst sowohl ein teilweises als auch ein vollständiges Ablösen einer Beschichtung von einer an die Beschichtung angrenzende Schicht.

Der Indikatorabschnitt weist die gleiche mindestens eine wärmeleitfähige Komponente und die mindestens eine Beschichtung auf, welche auch im ersten Bereich der Leiterplatte angeordnet sind. Der Indikatorabschnitt kann den ersten Bereich der Leiterplatte repräsentieren oder diesem vollständig oder teilweise entsprechen, wobei zumindest die mindestens eine Beschichtung und die mindestens eine wärmeleitfähige Komponente übernommen werden. Beispielsweise kann der Indikatorabschnitt eine Fläche von 4-5 mm² einnehmen. Auf diese Weise kann anhand des Indikatorabschnitts erkannt werden, ob eine Delamination der mindestens einen Beschichtung stattgefunden hat. Der Indikatorabschnitt dient damit als Prüfling für die Delamination der mindestens einen Beschichtung. Der Indikatorabschnitt kann bevorzugt außerhalb des ersten Bereichs der Leiterplatte angeordnet sein.

Beim Einbringen der Leiterplatte in den Ofen und dem Durchführen des mindestens einen Heizvorgangs wird durch die mindestens eine wärmeleitende Komponente Wärme in den Bereich der mindestens einen Beschichtung eingebracht. Ist im Bereich der mindestens einen Beschichtung zu viel Feuchtigkeit enthalten, so kommt es beim Erwärmen zur Verdampfung von Wasser und/oder Lösungsmittel und infolgedessen zur Ablösung der mindestens einen Beschichtung von einer an die mindestens eine Beschichtung angrenzenden Schicht der Leiterplatte. Nach dem Heizvorgang genügt es also, lediglich den Indikatorabschnitt hinsichtlich einer Delamination zu überprüfen, da das Ergebnis der Prüfung auf den ersten Bereich der Leiterplatte übertragbar ist. Die mindestens eine Beschichtung ist insbesondere eine innenliegende Schicht der Leiterplatte und nicht an einer Oberfläche der Leiterplatte angeordnet.

Wird festgestellt, dass im Indikatorabschnitt keine Delamination aufgetreten ist, so wird davon ausgegangen, dass auch im ersten Bereich der Leiterplatte keine Delamination stattgefunden hat. Wird hingegen festgestellt, dass im Indikatorabschnitt eine Delamination stattgefunden hat, so wird davon ausgegangen, dass im ersten Bereich der Leiterplatte ebenfalls eine Delamination stattgefunden hat und die Leiterplatte damit beeinträchtigt ist. Weiterhin kann davon ausgegangen werden, dass die Charge, aus der die untersuchte Leiterplatte stammt, anfällig für Delamination ist. Folglich können entsprechende Schritte unternommen werden, wie das Beseitigen der Charge oder das Durchführen von Trocknungsprozessen an den Leiterplatten der Charge.

In einer Ausgestaltung weist die mindestens eine wärmeleitende Komponente ein Metall auf.

Insbesondere weist die mindestens eine wärmeleitende Komponente Kupfer auf.

In einer weiteren Ausgestaltung weist die mindestens eine wärmeleitende Komponente mindestens eine Kupferschicht und/oder mindestens eine metallisierte Durchgangsbohrung auf.

Bevorzugterweise wird der mindestens eine Indikatorabschnitt mittels einer Topologiemessung hinsichtlich einer Delamination überprüft. Durch die Delamination der mindestens einen Beschichtung kann es zu einer Wölbung der mindestens einen Beschichtung oder einer der an die mindestens eine Beschichtung angrenzenden Schicht kommen. Im Bereich der delaminierten Beschichtung ist die Leiterplatte also nicht plan. Anhand der Topologiemessung wird eine solche Wölbung erkannt.

Vorteilhafterweise wird der mindestens eine Indikatorabschnitt mittels einer optischen Prüfung hinsichtlich einer Delamination überprüft. Die optische Prüfung kann eine Topologiemessung umfassen.

Insbesondere wird die optische Prüfung während einer automatischen optischen Inspektion durchgeführt. Bei der automatischen optischen Inspektion (AOI) werden die Bauteile mittels einem Bildverarbeitungsverfahren überprüft, bspw. hinsichtlich ihrer Lötstellen. Dieses Verfahren kann zusätzlich dazu genutzt werden, um eine Delamination der mindestens einen Beschichtung zu erkennen. Typischerweise wird die automatische optische Inspektion nach dem Verlöten von Bauteilen mit der Leiterplatte durchgeführt.

In einer Weiterbildung ist der mindestens eine Indikatorabschnitt auf einem Nutzenrand der Leiterplatte angeordnet. Der Nutzenrand wird später von der Leiterplatte entfernt. Der mindestens eine Indikatorabschnitt nimmt somit keinen Platz auf der Leiterplatte ein.

In einer anderen Weiterbildung ist der Ofen ein Reflow-Ofen.

In einer Ausgestaltung wird die Leiterplatte vor dem Einbringen in den Ofen mit einer Lötpaste bedruckt. Die Lötpaste kann im Ofen umgeschmolzen werden, um Lotdepots zu formen, oder die Lötpaste wird aufgeschmolzen, um ein Bauteil bzw. Bauteile mit der Leiterplatte zu verlöten. Das Erkennen einer Delamination der mindestens einen Beschichtung kann in den Lötprozess integriert werden, so dass nach dem Lötprozess überprüft wird, ob eine Delamination der mindestens einen Beschichtung stattgefunden hat.

In einer weiteren Ausgestaltung wird die Leiterplatte vor dem Einbringen in den Ofen mit Bauteilen bestückt. Die Bauteile werden im Ofen während eines Heizvorganges mit der Leiterplatte verlötet. Nach dem Heizvorgang kann überprüft werden, ob eine Delamination der mindestens einen Beschichtung stattgefunden hat.

Bevorzugterweise werden die drei ersten Schritte des Verfahrens nach definierten Zeitpunkten wiederholt, um nach den definierten Zeitpunkten festzustellen, ob eine Delamination im mindestens einen Indikatorabschnitt aufgetreten ist. Die definierten Zeitpunkte können dabei auf Prozessschritte der Leiterplatte abgestimmt sein. Beispielsweise können nach definierten Prozessschritten wie einem ersten Lötprozess und einem zweiten Lötprozess jeweils die drei ersten Schritte des Verfahrens durchgeführt werden. Es kann passieren, dass eine Delamination nicht nach dem Heizvorgang des ersten Lötprozesses, sondern erst nach dem Heizvorgang des zweiten Lötprozesses auftritt, weil z.B. die Temperaturen im ersten Lötprozess nicht hoch genug waren, um eine Delamination auszulösen.

**In** einer Ausgestaltung ist die mindestens eine Beschichtung derart ausgestaltet, dass sie Feuchtigkeit aufnimmt oder Feuchtigkeit speichert.

**In** einer weiteren Ausgestaltung weist die mindestens eine Beschichtung Polyimid auf. Wie eingangs beschrieben kann Polyimid Feuchtigkeit aufnehmen oder speichern, die unter der Einwirkung von Wärme eine Delamination der mindestens einen Beschichtung bewirken kann.

Die vorliegende Erfindung wird anhand der nachfolgenden Figuren Fig. 1 - 5 näher erläutert werden. Sie zeigen:
Fig. 1: schematische Darstellung eines Feldgeräts mit einer Leiterplatte.
Fig. 2: schematischer Aufbau einer starrflexiblen Leiterplatte.
Fig. 3: schematischer Aufbau einer starrflexiblen Leiterplatte mit einer Delamination.
Fig. 4: schematische Darstellung einer Leiterplatte mit einem Indikatorabschnitt.
Fig. 5: eine weitere Ausgestaltung einer Leiterplatte mit einem Indikatorabschnitt.

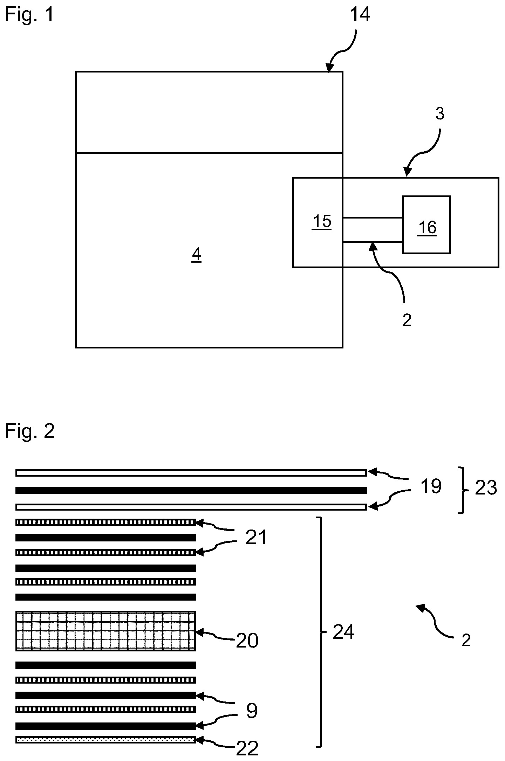

In Fig. 1 ist ein Schema eines beispielhaften Feldgeräts 3 gezeigt. Das Feldgerät 3 ist beispielsweise an einem, ein Medium 4 umfassendes, Behältnis 14, wie einem Tank oder einem Rohr, angeordnet und umfasst eine Sensoreinheit 15 und eine Elektronikeinheit 16. Die Sensoreinheit 15 ragt in das Medium 4 hinein und ist mittels einer Leiterplatte 2 mit der Elektronikeinheit 16 verbunden. Die Leiterplatte 2 kann auch Teil der Elektronikeinheit 16 und/oder der Sensoreinheit 15 sein.

Fig. 2 stellt einen typischen Querschnitt einer starrflexiblen Leiterplatte 2 dar. Polyimidschichten 19 sind in weiß dargestellt, Kupferschichten 9 in schwarz, Prepregschichten 21 schwarz-weiß gestreift, die Kernschicht 20 des starren Abschnitts der Leiterplatte 2 kariert und die Lötstoppschicht 22 gepunktet. Der flexible Abschnitt 23 der Leiterplatte 2 wird durch die obersten drei Schichten, zwei Polyimidschichten 19 und eine Kupferschicht 9, dargestellt. Die oberste Polyimidschicht 19 kann ggf. eine Lötstoppschicht 22 umfassen (nicht gezeigt). Die weiteren Schichten stellen den starren Abschnitt 24 der Leiterplatte 2 dar. Fig. 2 zeigt lediglich einen Ausschnitt der starrflexiblen Leiterplatte 2.

Der Kern 20 ist üblicherweise aus einem Verbundwerkstoff, wie FR4, gefertigt. Angrenzend an den Kern 20 sind zwei Kupferschichten 9 angeordnet, welche für die elektrische Leitfähigkeit innerhalb der Leiterplatte 2 sorgen. Zwischen den Kupferschichten 9 ist zumeist eine Schicht aus Prepreg 21 aufgetragen. An dem Übergang zwischen dem starren Abschnitt 24 und dem flexiblen Abschnitt 23 werden eine Polyimidschicht 19 und eine Prepregschicht 21 miteinander verbunden, insbesondere geklebt. An diesem Übergang kann es bei Wärmeeintrag zu einer Delamination der Polyimidschicht 19 von der Prepregschicht 21 kommen, welche zu einer Ablösung oder Abhebung der Polyimidschicht 19 von der Prepregschicht 21 führt. Der Wärmeeintrag wird insbesondere durch die wärmeleitenden Kupferschichten 9 begünstigt. Auch eine einzelne Kupferschicht 9 kann bereits zu einem solchen Wärmeeintrag führen, dass es zu einer Delamination kommt. Die Delamination ist als Wölbung auf der Leiterplatte 2 sichtbar und kann ggf. mittels einer Topologiemessung, beispielsweise im Rahmen einer automatischen optischen Prüfung, erkannt werden.

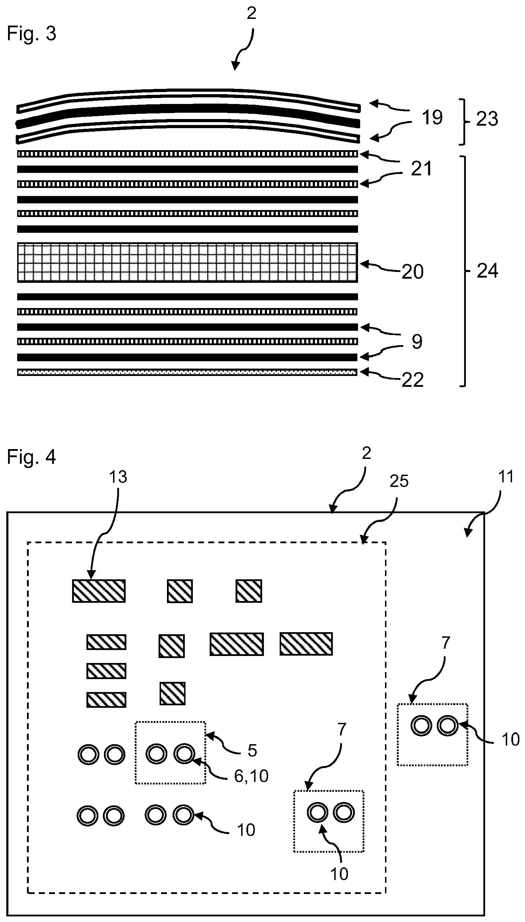

Ein Beispiel für eine solche Delamination ist in Fig. 3 dargestellt. In Fig. 3 hat sich die Polyimidschicht 19 an der Grenze zwischen dem flexiblen Abschnitt 23 und dem starren Abschnitt 24 von der Prepregschicht 21 abgelöst, was zur Folge hat, dass sich die Schichten des flexiblen Abschnitts 23 der Leiterplatte 2 wölben. Je nach Größe der Wölbung kann diese mit dem Auge erkennbar sein oder nicht. Da eine Leiterplatte 2 typischerweise mit einer Reihe an Bauteilen verlötet ist, ist die Wölbung ggf. nicht sichtbar, da sie durch die Bauteile (teilweise) verdeckt ist. In solchen Fällen kann der Indikatorabschnitt 7 abseits der elektronischen Schaltung 25 auf der Leiterplatte 2 oder sogar auf dem Nutzenrand 11 angeordnet sein. Selbst wenn die Leiterplatte 2 mit Bauteilen verlötet wurde, kann anhand des Indikatorabschnitts 7 eine Überprüfung hinsichtlich der Delamination durchgeführt werden, da in diesem bevorzugterweise keine Bauteile angeordnet sind.

Fig. 4 zeigt eine schematische Darstellung einer Leiterplatte 2 mit zwei beispielhaften Indikatorabschnitten 7. Die Leiterplatte 2 umfasst einen Bereich für eine elektronische Schaltung 25 und einen Nutzenrand 11. Innerhalb des Bereichs für die elektronische Schaltung 25 sind mehrere Bauteile 13 mit der Leiterplatte 2 verlötet. Weiterhin sind mehrere metallisierte Durchgangsbohrungen 10 in der Leiterplatte angeordnet, welche zum Verlöten weiterer Bauteile dienen und welche beispielsweise aus Kupfer bestehen. Der erste Bereich 5 der Leiterplatte 2 umfasst zumindest die mindestens eine Beschichtung 1 (hier nicht explizit dargestellt) und eine wärmeleitende Komponente 6, welche in diesem Beispiel in Form der metallisierten Durchgangsbohrungen 10 dargestellt ist. Alternativ oder zusätzlich kann der erste Bereich 5 weitere wärmeleitende Komponenten 6 aufweisen, wie z.B. eine oder mehrere Kupferschichten 9.

Nach dem Verlöten von Bauteilen 13 mittels der metallisierten Durchgangsbohrungen 10 sind die metallisierten Durchgangsbohrungen 10 und der erste Bereich 5 im Wesentlichen durch die Bauteile verdeckt, so dass eine Delamination ggf. nicht erkannt wird. Hierfür kann der Indikatorabschnitt 7, welcher ebenfalls die mindestens eine Beschichtung 1 und die wärmeleitende Komponente 6 aufweist, abseits der elektronischen Schaltung 25 angeordnet sein, entweder auf einem freien Bereich der Leiterplatte 2 oder auf dem Nutzenrand 11. Im Indikatorabschnitt 7 wird vorzugsweise kein Bauteil 13 verlötet.

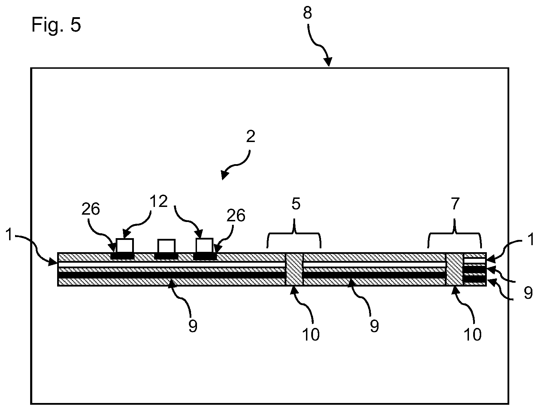

In Fig. 5 ist eine weitere Ausgestaltung einer Leiterplatte 2 gezeigt. Die Leiterplatte 2, gezeigt im Querschnitt, weist im ersten Bereich die mindestens eine Beschichtung 1, eine metallisierte Durchgangsbohrung 10 und eine Kupferschicht 9 auf. Der Indikatorabschnitt 7 weist ebenfalls die mindestens eine Beschichtung 1 und eine metallisierte Durchgangsbohrung 10 auf. Gegenüber dem ersten Bereich 5 weist der Indikatorabschnitt 7 jedoch nicht nur eine Kupferschicht 9, sondern zwei Kupferschichten 9 auf. Indem die Anzahl und/oder das Volumen der wärmeleitfähigen Komponenten 6 im Indikatorabschnitt 7 gegenüber dem ersten Bereich 5 erhöht wird, wird erreicht, dass der Indikatorabschnitt 7 empfindlicher gegenüber einem Wärmeeintrag und einer Delamination als der erste Bereich 5 ist. Dies kann von Vorteil sein, um auch geringfügige Delaminationen mittels des erfindungsgemäßen Verfahrens erkennen zu können.

Beispielhaft sind in Fig. 5 mehrere Lötpads 26 gezeigt, auf welche jeweils Lötpaste 12 gedruckt wurde. Im gezeigten Beispiel wird die Leiterplatte 2 in einen Ofen 8 eingebracht, in welchem ein Heizvorgang durchgeführt wird. Beispielsweise wird die Lötpaste 12 umgeschmolzen und die Leiterplatte 2 nach dem Umschmelzen mit Bauteilen 13 versehen und in einem zweiten Heizvorgang mit diesen verlötet.

### Bezugszeichenliste

- 1: Beschichtung
- 2: Leiterplatte
- 3: Feldgerät
- 4: Medium
- 5: erster Bereich
- 6: wärmeleitende Komponente
- 7: Indikatorabschnitt
- 8: Ofen
- 9: Kupferschicht
- 10: metallisierte Durchgangsbohrung
- 11: Nutzenrand
- 12: Lötpaste
- 13: Bauteile
- 14: Behältnis
- 15: Sensoreinheit
- 16: Elektronikeinheit
- 19: Polyimidschicht
- 20: Kern der starren Leiterplatte
- 21: Prepreg
- 22: Lötstoppschicht
- 23: flexibler Abschnitt der Leiterplatte
- 24: starrer Abschnitt der Leiterplatte
- 25: elektronische Schaltung
- 26: Lötpad

## Patentansprüche

1. Verfahren zum Erkennen einer Delamination mindestens einer Beschichtung (1) einer Leiterplatte (2) eines Feldgeräts (3) der Prozess- und Automatisierungstechnik, welches zur Bestimmung und/oder Überwachung mindestens eines chemischen und/oder physikalischen Parameters eines Mediums (4) dient, wobei die Leiterplatte (2) einen ersten Bereich (5) mit der mindestens einen Beschichtung (1) aufweist, wobei mindestens eine wärmeleitende Komponente (6) im Bereich der mindestens einen Beschichtung (1) angeordnet ist, wobei mindestens ein Indikatorabschnitt (7) auf der Leiterplatte (2) angeordnet ist, welcher die mindestens eine Beschichtung (1) und die mindestens eine wärmeleitende Komponente (6) aufweist, wobei das Verfahren zumindest die folgenden Schritte umfasst:
- Einbringen der Leiterplatte (2) in einen Ofen (8) und Durchführen mindestens eines Heizvorgangs,
- Überprüfen des mindestens einen Indikatorabschnitts (7) nach dem mindestens einen Heizvorgang hinsichtlich einer Delamination,
- Feststellen, ob eine Delamination im mindestens einen Indikatorabschnitt (7) während des mindestens einen Heizvorgangs aufgetreten ist.

2. Verfahren nach Anspruch 1,
wobei die mindestens eine wärmeleitende Komponente (6) ein Metall aufweist.

3. Verfahren nach einem der Ansprüche 1-2,
wobei die mindestens eine wärmeleitende Komponente (6) Kupfer aufweist.

4. Verfahren nach einem der Ansprüche 1-3,
wobei die mindestens eine wärmeleitende Komponente (6) mindestens eine Kupferschicht (9) und/oder mindestens eine metallisierte Durchgangsbohrung (10) aufweist.

5. Verfahren nach einem der Ansprüche 1-4,
wobei der mindestens eine Indikatorabschnitt (7) mittels einer Topologiemessung hinsichtlich einer Delamination überprüft wird.

6. Verfahren nach einem der Ansprüche 1-5,
wobei der mindestens eine Indikatorabschnitt (7) mittels einer optischen Prüfung hinsichtlich einer Delamination überprüft wird.

7. Verfahren nach einem der Ansprüche 1-6,
wobei die optische Prüfung während einer automatischen optischen Inspektion durchgeführt wird.

8. Verfahren nach einem der Ansprüche 1-7,
wobei der mindestens eine Indikatorabschnitt (7) auf einem Nutzenrand (11) der Leiterplatte (2) angeordnet ist.

9. Verfahren nach einem der Ansprüche 1-8,
wobei der Ofen (8) ein Reflow-Ofen ist.

10. Verfahren nach einem der Ansprüche 1-9,
wobei die Leiterplatte (2) vor dem Einbringen in den Ofen (8) mit einer Lötpaste (12) bedruckt wird.

11. Verfahren nach einem der Ansprüche 1-10,
wobei die Leiterplatte (2) vor dem Einbringen in den Ofen (8) mit Bauteilen (13) bestückt wird.

12. Verfahren nach einem der Ansprüche 1-11,
wobei die drei ersten Schritte des Verfahrens nach definierten Zeitpunkten wiederholt werden, um nach den definierten Zeitpunkten festzustellen, ob eine Delamination im mindestens einen Indikatorabschnitt (7) aufgetreten ist.

13. Verfahren nach einem der Ansprüche 1-12,
wobei die mindestens eine Beschichtung (1) derart ausgestaltet ist, dass sie Feuchtigkeit aufnimmt.

14. Verfahren nach einem der Ansprüche 1-13,
wobei die mindestens eine Beschichtung (1) Polyimid aufweist.

## Claims

1. A method for detecting a delamination of at least one coating (1) of a printed circuit board (2) of a field device (3) in process and automation technology, the field device serving for determining and/or monitoring at least one chemical and/or physical parameter of a medium (4), wherein the printed circuit board (2) comprises a first region (5) having at least one coating (1), wherein at least one thermally conductive component (6) is arranged in the region of the at least one coating (1), wherein at least one indicator section (7) is arranged on the printed circuit board (2), the indicator section comprising the at least one coating (1) and the at least one thermally conductive component (6), the method comprising at least the following steps:
• introducing the printed circuit board (2) into an oven (8) and carrying out at least one heating process,
• inspecting the at least one indicator section (7) for delamination after the at least one heating process,
• determining whether a delamination has occurred in the at least one indicator section (7) during the at least one heating process.

2. The method according to claim 1, wherein the at least one thermally conductive component (6) comprises a metal.

3. The method according to claim 1 or 2, wherein the at least one thermally conductive component (6) comprises copper.

4. The method according to any one of claims 1 to 3, wherein the at least one thermally conductive component (6) comprises at least one copper layer (9) and/or at least one plated through-hole (10).

5. The method according to any one of claims 1 to 4, wherein the at least one indicator section (7) is inspected for delamination by means of a topography measurement.

6. The method according to any one of claims 1 to 5, wherein the at least one indicator section (7) is inspected for delamination by means of an optical inspection.

7. The method according to any one of claims 1 to 6, wherein the optical inspection is carried out during an automated optical inspection.

8. The method according to any one of claims 1 to 7, wherein the at least one indicator section (7) is arranged on a panel edge (11) of the printed circuit board (2).

9. The method according to any one of claims 1 to 8, wherein the oven (8) is a reflow oven.

10. The method according to any one of claims 1 to 9, wherein the printed circuit board (2) is printed with a solder paste (12) before being introduced into the oven (8).

11. The method according to any one of claims 1 to 10, wherein the printed circuit board (2) is populated with components (13) before being introduced into the oven (8).

12. The method according to any one of claims 1 to 11, wherein the first three steps of the method are repeated at defined points in time in order to determine, after the defined points in time, whether a delamination has occurred in the at least one indicator section (7).

13. The method according to any one of claims 1 to 12, wherein the at least one coating (1) is configured to absorb moisture.

14. The method according to any one of claims 1 to 13, wherein the at least one coating (1) comprises polyimide.

## Revendications

1. Procédé de détection d'une délamination d'au moins un revêtement (1) d'une carte de circuit imprimé (2) d'un appareil de terrain (3) de la technique des procédés et de l'automatisation, l'appareil de terrain servant à déterminer et/ou à surveiller au moins un paramètre chimique et/ou physique d'un fluide (4), la carte de circuit imprimé (2) comprenant une première zone (5) munie d'au moins un revêtement (1), au moins un composant thermoconducteur (6) étant disposé dans la zone du revêtement (1), au moins une section indicatrice (7) étant disposée sur la carte de circuit imprimé (2), la section indicatrice comprenant le revêtement (1) et le composant thermoconducteur (6), le procédé comprenant au moins les étapes suivantes :
• introduction de la carte de circuit imprimé (2) dans un four (8) et réalisation d'au moins un cycle de chauffage ;
• inspection de la section indicatrice (7) quant à une délamination après le cycle de chauffage ;
• détermination de l'apparition ou non d'une délamination dans la section indicatrice (7) pendant le cycle de chauffage.

2. Procédé selon la revendication 1, **caractérisé en ce que** le composant thermoconducteur (6) comprend un métal.

3. Procédé selon la revendication 1 ou 2, **caractérisé en ce que** le composant thermoconducteur (6) comprend du cuivre.

4. Procédé selon l'une quelconque des revendications 1 à 3, **caractérisé en ce que** le composant thermoconducteur (6) comprend au moins une couche de cuivre (9) et/ou au moins un trou métallisé (10).

5. Procédé selon l'une quelconque des revendications 1 à 4, **caractérisé en ce que** la section indicatrice (7) est inspectée quant à une délamination au moyen d'une mesure topographique.

6. Procédé selon l'une quelconque des revendications 1 à 5, **caractérisé en ce que** la section indicatrice (7) est inspectée quant à une délamination au moyen d'un contrôle optique.

7. Procédé selon l'une quelconque des revendications 1 à 6, **caractérisé en ce que** le contrôle optique est réalisé dans le cadre d'une inspection optique automatisée.

8. Procédé selon l'une quelconque des revendications 1 à 7, **caractérisé en ce que** la section indicatrice (7) est disposée sur un bord de panneau (11) de la carte de circuit imprimé (2).

9. Procédé selon l'une quelconque des revendications 1 à 8, **caractérisé en ce que** le four (8) est un four de refusion.

10. Procédé selon l'une quelconque des revendications 1 à 9, **caractérisé en ce que** la carte de circuit imprimé (2) est imprimée avec une pâte à braser (12) avant son introduction dans le four (8).

11. Procédé selon l'une quelconque des revendications 1 à 10, **caractérisé en ce que** la carte de circuit imprimé (2) est équipée de composants (13) avant son introduction dans le four (8).

12. Procédé selon l'une quelconque des revendications 1 à 11, **caractérisé en ce que** les trois premières étapes du procédé sont répétées à des instants définis afin de déterminer, après ces instants définis, si une délamination est apparue dans la section indicatrice (7).

13. Procédé selon l'une quelconque des revendications 1 à 12, **caractérisé en ce que** le revêtement (1) est conçu pour absorber l'humidité.

14. Procédé selon l'une quelconque des revendications 1 à 13, **caractérisé en ce que** le revêtement (1) comprend du polyimide.
